# EUROPEAN PATENT APPLICATION

(11) **EP 4 498 415 A1**
(43) Date of publication of application: **29.01.2025**
(21) Application number: 24190558.7
(22) Date of filing: 24.07.2024
(51) Int. Cl.: H01L 21/677, H01L 21/67

(54) **WAFER LOADING AND UNLOADING SYSTEM FOR AN EPITAXIAL REACTOR AND AN EPITAXIAL REACTOR**

(30) Priority: 27.07.2023 IT 202300015855
(71) Applicant: LPE S.p.A., 20021 Baranzate (MI) (IT)
(72) Inventor: MESCHIA, Maurilio Giuseppe, I-20021 Baranzate (Milano) (IT); COREA, Francesco, I-20021 Baranzate (Milano) (IT); POLLI, Stefano, I-20021 Baranzate (Milano) (IT); PRETI, Silvio Roberto Mario, I-20021 Baranzate (Milano) (IT)
(74) Representative: Di Biase, Fabio

(57) **Abstract**

**SUMMARY**

A system (1) for loading and unloading wafers (2) into a reaction chamber (3) of an epitaxial reactor (4), the system (1) comprising a handling robot (5); a linear actuator (6), extended along a translation axis (7), wherein the handling robot (5) is configured to transfer a wafer (2) to the linear actuator (6), and wherein the linear actuator (6) is configured to receive the wafer (2) from the handling robot (5) and to move the wafer (2) along the translation axis (7) so as to place the wafer (2) inside the reaction chamber (3).

## Description

### Field of the invention

The present invention relates to a wafer loading and unloading system for an epitaxial reactor, and an epitaxial reactor comprising such a loading and unloading system.

### Prior art

Known epitaxial reactors comprise a reaction chamber into which wafers are introduced, generally placed on a support, to undergo a process of epitaxial deposition of semiconductor material.

In known solutions, the wafer and its support are loaded and unloaded from the reaction chamber by a multi-articulated wafer handling robot, positioned within a wafer handling chamber facing and connected to the reaction chamber.

In known solutions, the robotic handling system comprises an articulated arm at the end of which an end handling device, or "end effector", is hinged. This end effector is suitable for grasping and inserting the wafer and the wafer support into the reaction chamber.

There is a need to reduce the footprint of the epitaxial reactor and in particular of the wafer loading and unloading system inside the reaction chamber of the epitaxial reactor.

In known solutions, however, due to the intense heat within the reaction chamber, the robot joints, and thus the articulated robotic arm, must be kept outside the reaction chamber, and only the end effector can extend inside the volume of the reaction chamber to deposit the wafer and its support.

Due to constraints imposed by the production process and the required yield requirements, both the reaction chamber and the end effector must have a certain minimum length. Therefore, in order to reduce the epitaxial reactor footprint, the possibility of reducing the length of the reaction chamber or of the end effector is limited.

In fact, since the end effector must be long enough to transfer wafers into and out of the reaction chamber, the handling chamber must be large enough to ensure rotation of the handling robot, and in particular of the end effector and the robotic articulated arm to which the end effector is connected, during wafer loading and unloading operations.

A conceivable technical solution for reducing the footprint of known loading and unloading systems would be to position a plurality of reaction chambers in a radial arrangement with respect to a single handling robot. However, such a technical solution would also result in a large footprint and would not attain the required footprint reduction.

### Solution

The object of the present invention is to make available a wafer loading and unloading system for an epitaxial reactor, and an epitaxial reactor comprising the loading and unloading system, so as to solve at least some of the problems noted in the prior art.

A primary object of the present invention is to make available a wafer loading and unloading system for an epitaxial reactor, and an epitaxial reactor comprising the loading and unloading system, with reduced overall dimensions in order to maximize wafer production density.

This and other objects are achieved by a wafer loading and unloading system for an epitaxial reactor, and an epitaxial reactor comprising the loading and unloading system, according to the independent claims.

The dependent claims relate to preferred and advantageous embodiments of the present invention.

### Figure

To better understand the invention and appreciate its advantages, several of its illustrative and non-limiting embodiments will be described below, referencing the accompanying figures, wherein:

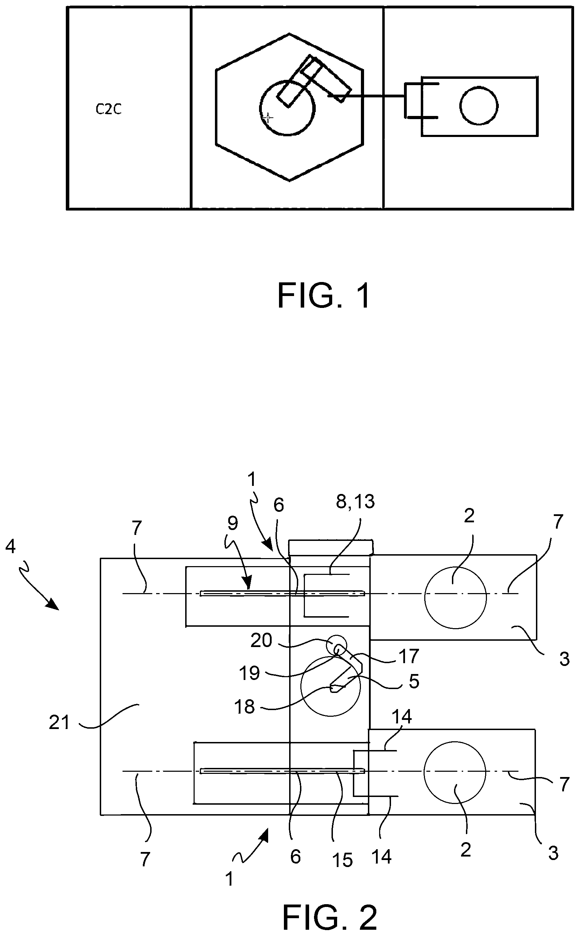

- Figure 1 is a schematic top view of an epitaxial reactor, according to the prior art;
- Figure 2 is a schematic top view of an epitaxial reactor, according to one embodiment of the invention;
- Figure 3 is a schematic top view of a wafer loading and unloading system of an epitaxial reactor, according to one embodiment of the invention, in an initial operational configuration;
- Figure 4 is a schematic top view of the loading and unloading system depicted in Figure 3, in another operational configuration;
- Figure 5 is a schematic top view of the loading and unloading system depicted in Figure 3, in another operational configuration;
- Figure 6 is a schematic top view of the loading and unloading system depicted in Figure 3, in another operational configuration;
- Figure 7 is a perspective cross-sectional view of a wafer loading and unloading system of an epitaxial reactor, according to one embodiment of the invention;
- Figure 8 is a perspective view of a component of the loading and unloading system depicted in Figure 7, in an initial operating configuration;
- Figure 9 is a perspective view of a component of the loading and unloading system depicted in Figure 7, in a second operating configuration;
- Figure 10 is a perspective view of a component of the loading and unloading system depicted in Figure 7, in a third operational configuration;
- Figure 11 is a side view of the loading and unloading system, according to one embodiment, in an initial operating configuration;
- Figure 12 is a side view of the loading and unloading system, according to one embodiment, in a second operating configuration.

### Description of some preferred examples accomplished

With reference to the figures, a loading and unloading system is generally indicated with the reference number 1.

The loading and unloading system 1 is configured to load and unload wafers 2 into a reaction chamber 3 of an epitaxial reactor 4.

According to one embodiment, the wafers 2 are placed on respective wafer supports, and the system 1 is configured to move the wafer supports on which the wafers 2 are placed.

According to a further embodiment, the wafers 2 are not placed on a wafer support. In accordance with this embodiment, the system 1 is configured to directly move the wafers 2.

The system 1 comprises a handling robot 5.

In one aspect of the invention, the system 1 comprises a linear actuator 6. The linear actuator 6 is extended along a translation axis 7.

The handling robot 5 is configured to transfer a wafer 2 to the linear actuator 6.

In addition, the linear actuator 6 is configured to receive the wafer 2 from the handling robot 5.

The linear actuator 6 is further configured to advance the wafer 2 along the translation axis 7, so as to place the wafer 2 inside the reaction chamber 3.

Advantageously, such a configured loading and unloading system 1 has a smaller footprint than the prior art. In particular, a system 1 thus configured enables the use of handling robots 5 with articulated arms of reduced length. In addition, such a configured system 1 enables the use of end effector components of reduced length compared to the prior art. With a further advantage, the space below the linear actuator 6 is unoccupied and can therefore be used for the positioning of additional components, thus further reducing the total footprint of the system 1.

According to one embodiment, the handling robot 5 and the linear actuator 6 are configured to move the wafer supports on which the wafers 2 are placed.

According to a further embodiment, the handling robot 5 and the linear actuator 6 are configured to directly move the wafers 2.

According to one embodiment, the linear actuator 6 comprises a transport device 8.

The transport device 8 is configured to receive and support the wafer 2 transferred from the handling robot 5.

In addition, the transport device 8 is configured to transport the wafer 2 along the translation axis 7. In this way, the transport device 8 can load the wafer 2 into the reaction chamber 3.

According to one embodiment, the transport device 8 is configured to move the wafer supports on which the wafers 2 are placed.

According to a further embodiment, the transport device 8 is configured to directly move the wafers 2.

According to one embodiment, the linear actuator 6 comprises a track 9.

The track 9 is extended in a direction parallel to the translation axis 7.

The transport device 8 is connected to the track 9.

The track 9 is configured to guide the movement of the transport device 8 along the translation axis 7.

The track 9 extends from one start of travel limit 10 and an opposite end of travel limit 11. The end of travel limit 11 is facing the reaction chamber 3, while the start of travel limit 10 is facing the reaction chamber 3.

According to one embodiment, the linear actuator 6 comprises a drive system 12.

The drive system 12 is configured to drive the movement of the transport device 8 along the track 9, in the direction of the translation axis 7.

According to one embodiment, the drive system 12 is an electromechanical drive system.

According to one embodiment, the transport device 8 is a fork 13.

The fork 13 comprises at least two prongs 14, preferably only two prongs 14.

In addition, the fork 13 comprises a handle 15 connected to at least two prongs 14.

The fork 13 is facing the reaction chamber 3.

Specifically, the prongs 14 are positioned substantially parallel to the translation axis 7.

The handle 15 is also extended parallel to the translation axis 7; in particular, it is extended along the translation axis 7.

In addition, the handle 15 is positioned opposite the reaction chamber 3, relative to the prongs 14.

In accordance with such a configuration, the fork 13 is configured to support the wafer 2 received from the handling robot 5, transport the wafer 2 to the reaction chamber 3, along the translation axis 7, and deposit the wafer 2 into the reaction chamber 3. The wafer 2 is supported by the prongs 14 of the fork 13.

In addition, following processing of the wafer 2, the fork 13 is configured to pick up the wafer 2 from the reaction chamber 3, via the prongs 14, and move and position the wafer 2 relative to the handling robot 5, so as to allow a transfer of the processed wafer 2 to the handling robot 5.

According to one embodiment, the fork 13 is configured to move, support, deposit, and pick up the wafer support on which the wafer 2 is placed.

According to a further embodiment, the fork 13 is configured to directly move, support, deposit and pick up the wafer 2.

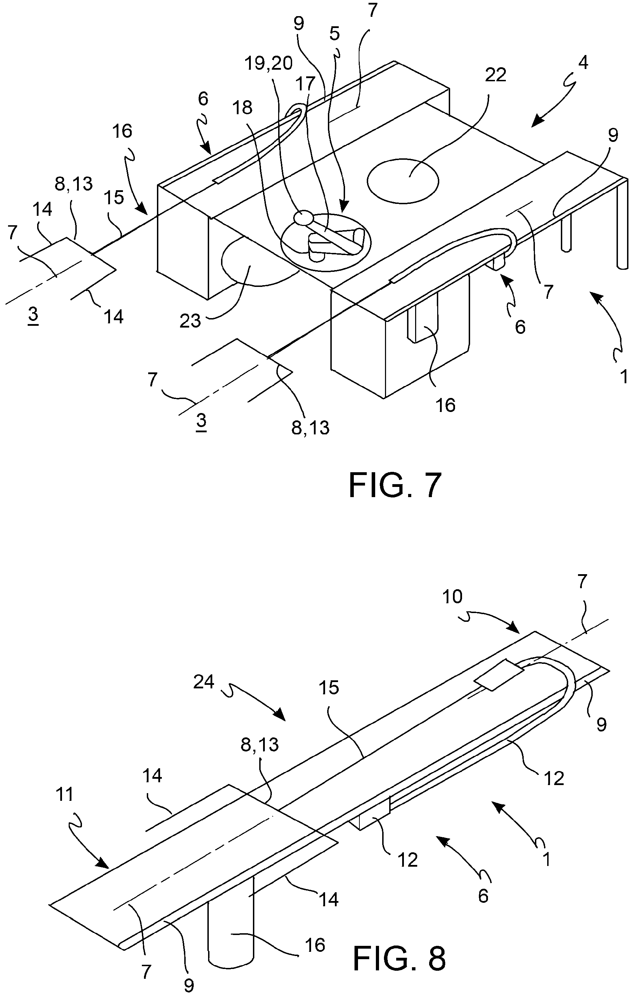

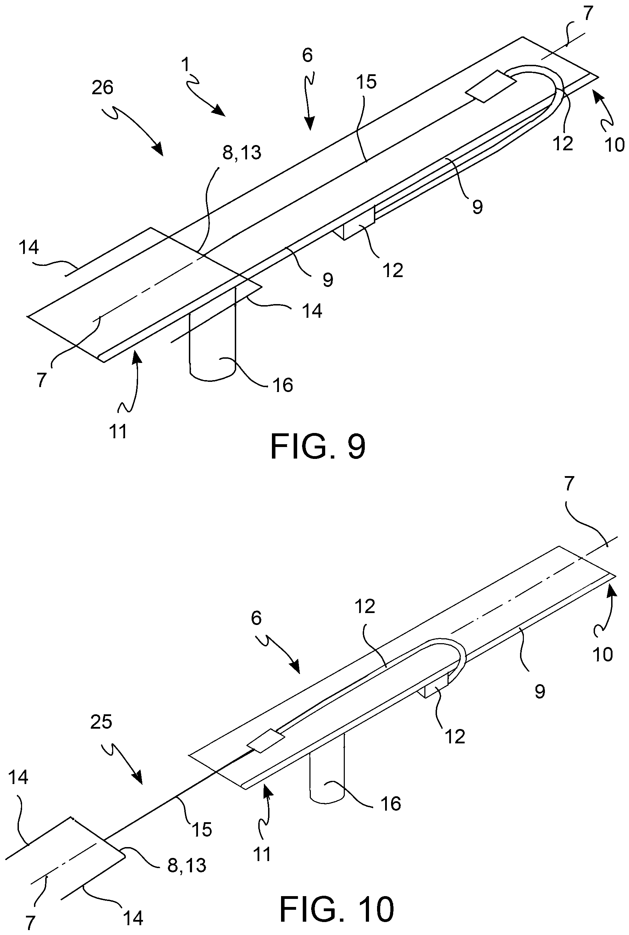

According to one embodiment, the transport device 8 can be moved from a start of travel position 24 **(****Fig. 8****),** or resting position, to an end of travel position 25 **(****Fig. 10****),** or deposit and withdrawal position of the wafer 2 from the reaction chamber 3.

Moreover, the transport device 8 can be moved to a transfer position 26 **(****Fig. 9****)** interposed between the start of travel position 24 and the end of travel position 25.

Specifically, the transport device 8 is configured to receive the wafer 2 from the handling robot 5 when the transport device 8 is put in the transfer position 26.

Preferably, the transport device 8 is also configured to transfer the wafer 2, following processing, to the handling robot 5, when the transport device 8 is put in the transfer position 26.

According to one embodiment, the handling robot 5 is positioned laterally to the linear actuator 6, relative to the transfer position 26.

"Laterally" means laterally with respect to the translation axis 7, in a horizontal plane, therefore not aligned along the translation axis 7.

According to the embodiment wherein the transport device 8 is a fork 13, the start of travel position 24 corresponds to a fork position 13 wherein an end of the handle 15 opposite the prongs 14 is positioned substantially at the start of travel limit 10 of the track 9.

In addition, the end position 25 corresponds to a fork position 13 wherein the end of the handle 15 opposite the prongs 14 is positioned substantially at the end of travel end 11 of the track 9. In the end position 25, the prongs 14 extend beyond the track 9. In addition, the handle 15 protrudes from the track 9. In this way, the prongs 14 and a portion of the handle 15 can be introduced into the reaction chamber 3 so as to deposit the wafer 2 therein.

Advantageously, such a configuration enables the use of a fork 13 of reduced length compared to the "end effectors" of the prior art. In fact, such a configuration of the system 1 does not require providing additional space to allow a translational-rotational movement of the fork to insert the wafer inside the reaction chamber. In contrast, the fork 13 thus configured does not perform a rotation, but a movement in the direction of the translation axis 7 to deposit and withdraw the wafer 2 from the reaction chamber 3. Such a movement therefore requires a smaller footprint than the prior art, and also requires a fork 13 of reduced size with respect to the prior art.

According to one embodiment, the system 1 comprises a lifting system 16.

The lifting system 16 is connected to the linear actuator 6.

The lifting system 16 is configured to advance the linear actuator 6 along a direction transverse to the translation axis 7.

Specifically, the lifting system 16 is configured to vertically advance the linear actuator 6; i.e., to move the linear actuator 6 along a direction substantially transverse to a plane defined by the transport device 8; i.e., the fork 13.

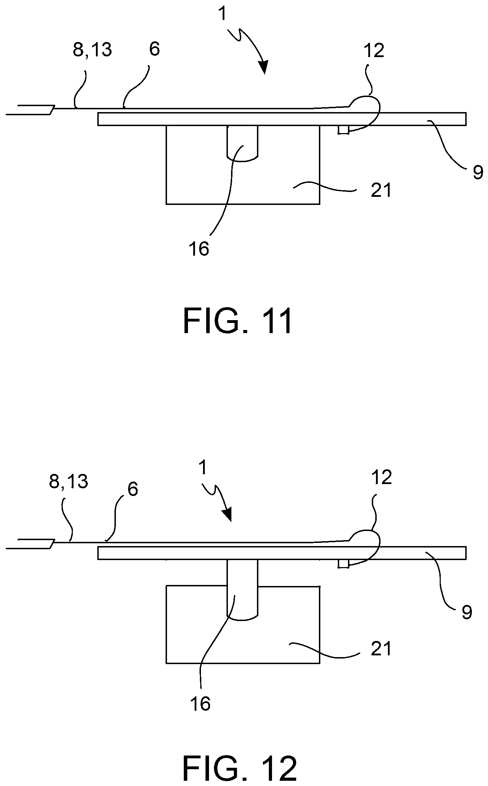

In particular, the lifting system 16 is configured to vertically advance the linear actuator 6 with respect to the handling robot 5 **(****Fig. 11-12****).**

Advantageously, the lifting system 16 thus configured allows the linear actuator 6, and in particular the transport device 8, to be raised and lowered vertically relative to the handling robot 5. In this way, by lifting the linear actuator 6, the transport device 8 is able to receive or pick up the wafer 2 from the handling robot 5, by grasping the wafer 2 with the fork, and subsequently inserting the wafer 2 inside the reaction chamber 3. Specifically, the transport device 8 is able to receive or pick up the wafer support on which the wafer 2 is placed by the handling robot 5, by grasping the wafer support with the fork, and subsequently inserting the wafer support on which the wafer 2 is placed into the reaction chamber 3. Similarly, by lowering the linear actuator 6, the transport device 8 is capable of transferring the wafer 2 to the handling robot 5 following processing of the wafer 2. Furthermore, the transport device 8 is capable of depositing the wafer 2 or the wafer support on which the wafer 2 is placed in the reaction chamber 3 by lowering the linear actuator 6. Conversely, the transport device 8 is capable of picking up the wafer 2 from the reaction chamber 3 by raising the linear actuator 6, so as to directly grasp with the fork the wafer 2 or the wafer support on which the wafer 2 is placed.

According to one embodiment, the lifting system 16 is configured to vertically move the linear actuator 6 when the transport device 8 is in the transfer position 26.

According to one embodiment, the lifting system 16 is configured to vertically move the linear actuator 6 when the transport device 8 is in the end of travel position 25.

According to one embodiment, the lifting system 16 is configured to vertically and jointly move the transport device 8, in particular the fork 13, and the track 9.

According to one embodiment, the lifting system 16 is a hydraulic-type system. Alternatively, the lifting system 16 is a pneumatic-type system. Alternatively, the lifting system 16 is an electromechanical-type system.

According to one embodiment, the lifting system 16 is positioned below the track 9.

According to one embodiment, the system 1 is configured so that when the transport device 8 moves between the transfer position 26 and the end of travel position 25 and vice versa, transporting a wafer 2, the transport device 8 is in a raised configuration. Furthermore, when the transport device 8 moves between the transfer position 26 and the end of travel position 25 and vice versa, without transporting a wafer 2, the transport device 8 is in a lowered configuration.

"Raised configuration" and "lowered configuration" are defined as a maximum and minimum height dimension achieved by the transport device 8, by means of the lifting system 16, relative to the handling robot 5.

According to one embodiment, the system 1 comprises two linear actuators 6.

The two linear actuators 6 are positioned opposite each other with respect to a handling robot 5.

In addition, the linear actuators 6 are positioned parallel to each other.

Specifically, both linear actuators 6 define a respective translation axis 7. The respective translation axes 7 defined by the two linear actuators 6 are parallel but not overlapping.

Specifically, each linear actuator 6 can be positioned facing a respective reaction chamber 3. Thus, the translation axis 7 defined by the respective linear actuator 6 is directed towards the respective reaction chamber 3.

Advantageously, such a configuration provides a further reduction of the overall footprint of the system 1. In fact, two respective linear actuators 6, and consequently two respective reaction chambers 3, can be fed by means of a single handling robot 5. With further advantage, the parallel arrangement of the two linear actuators 6, between which the handling robot 5 is interposed, minimizes the overall footprint of the system 1.

According to one embodiment, the two linear actuators 6 are mirror positioned with respect to a symmetry plane 27 vertical and parallel to the translation axis 7 and passing by the handling robot 5.

Each linear actuator 6 may comprise all features previously discussed and not repeated herein to avoid redundancies.

According to one embodiment, the system 1 comprises four linear actuators 6, which define two pairs of linear actuators 6. Each linear actuator 6 is positioned along a direction parallel to the translation axis 7.

Specifically, the two pairs of linear actuators 6 are positioned respectively opposite with respect to the handling robot 5. Thus, the system 1 comprises two linear actuators 6 adjacent to and parallel to each other, positioned on one side of the handling robot 5. Furthermore, the system 1 comprises two additional linear actuators 6 adjacent to each other and parallel, positioned on one side of the handling robot 5 opposite the side on which the other two linear actuators 6 are positioned.

Advantageously, such a configuration allows four distinct linear actuators 6, and thus four distinct reaction chambers 3, to be fed by a single handling robot 5 interposed between the two pairs of linear actuators 6.

According to one embodiment, the handling robot 5 is configured to pick up the wafer 2 from one or more linear actuators 6, in particular following the process of epitaxial deposition on the wafer 2.

The following description will refer to a linear actuator 6, but it is to be understood as also applicable to the embodiment wherein the system 1 comprises two linear actuators 6 parallel and opposite with respect to the handling robot 5.

According to one embodiment, the handling robot 5 is positioned laterally to the linear actuator 6.

Specifically, the handling robot 5 is configured to transfer a wafer 2, directly or supported by a wafer support, to the linear actuator 6 by moving the wafer 2 along a direction substantially transverse to the translation axis 7.

Similarly, the handling robot 5 is configured to pick up the wafer 2 from the linear actuator 6, either directly or by picking up the wafer support on which the wafer 2 is positioned, along a direction substantially transverse to the translation axis 7.

Advantageously, such a configuration minimizes the footprint of the handling robot 5 and of the linear actuator 6, and the movement of the wafer 2 to be loaded or unloaded from the linear actuator 6 via the handling robot 5.

According to one embodiment, the handling robot 5 comprises an articulated arm 17.

The articulated arm 17 is extended between a fulcrum end 18 and an opposite gripping end 19.

The articulated arm 17 may comprise a plurality of joints and articulated segments interposed between the fulcrum end 18 and the gripping end 19.

According to one embodiment, the handling robot 5 comprises an end effector 20.

The end effector 20 is connected to the articulated arm 17 at the gripping end 19.

The end effector 20 is configured to move the wafers 2. In addition, the end effector 20 is configured to deposit or pick up the wafers 2 from the linear actuator 6, and in particular from the transport device 8.

According to one embodiment, the end effector 20 is configured to move the wafer support on which the wafer 2 is positioned.

According to a further embodiment, the end effector 20 is configured to directly move the wafer 2.

According to one embodiment, the end effector 20 can be moved on a handling plane, parallel to the translation axis 7, fixed with respect to a frame 21 of the epitaxial reactor 4.

In a further aspect of the invention, an epitaxial reactor 4 comprises at least one reaction chamber 3 and a loading and unloading system 1 as previously described.

The reaction chamber 3 is positioned along the translation axis 7 defined by the linear actuator 6.

Specifically, the reaction chamber 3 is positioned facing the linear actuator 6; i.e., open in the direction of the translation axis 7.

Accordingly, the linear actuator 6 is configured to move the wafer 2 along the translation axis 7, in the direction of the reaction chamber 3.

According to one embodiment, the epitaxial reactor 4 comprises two reaction chambers 3.

Moreover, the system 1 comprises two linear actuators 6 and a handling robot 5 interposed between the two linear actuators 6.

Specifically, the handling robot 5 is configured to operate with both linear actuators 6 between which it is positioned; i.e., to selectively transfer a wafer 2 to the two linear actuators 6, and pick up a wafer 2 from the two linear actuators 6.

The linear actuators 6 are positioned parallel to each other.

In addition, the reaction chambers 3 are facing a respective linear actuator 6.

According to one embodiment, the two reaction chambers 3 and the two linear actuators 6 are positioned opposite with respect to a plane parallel to the translation axis 7 defined by the linear actuators 6 and passing by the handling robot 5.

According to one embodiment, the two reaction chambers 3 and the two linear actuators 6 are mirror positioned with respect to a symmetry plane 27 parallel to the translation axis 7 defined by the linear actuators 6 and passing by the handling robot 5.

According to one embodiment, the handling robot 5 is configured to transfer a wafer 2 to one of the two linear actuators 6, and the subsequent wafer 2 to the other of the two linear actuators 6, alternately.

Advantageously, this enables the reduction of the overall production time of the processed wafers and thus increases the efficiency of the epitaxial reactor 4.

According to one embodiment, the epitaxial reactor 4 comprises a loading station 22 ("load lock").

The loading station 22 is configured to store a plurality of wafers 2 to be used in the reaction chambers 3 for the epitaxial deposition process.

Preferably, in the loading station 22, wafer pretreatment operations 2 can be performed, to prepare the wafers 2 for the next epitaxial deposition process.

Specifically, the handling robot 5 is configured to pick up from the loading station 22 a wafer 2 to be used in a reaction chamber 3, and then to be transferred to a linear actuator 6.

According to one embodiment, the epitaxial reactor 4 comprises a cooling station 23.

The cooling station 23 is configured to store a plurality of wafers 2 from the reaction chambers 3, thus on which the epitaxial deposition process was performed, to be removed from the linear actuator 6 by the handling robot 5.

In particular, the cooling station 23 is adapted to store the wafers 2 to be cooled following the epitaxial deposition process.

The cooling station 23 is distinct from the loading station 22.

According to one embodiment, the loading station 22 and/or the cooling station 23 are positioned interposed between the linear actuators 6 and the reaction chambers 3 of the epitaxial reactor 4.

According to one embodiment, the handling robot 5 is positioned interposed between the loading station 22 and the cooling station 23.

According to one embodiment, the handling robot 5, loading station 22 and/or cooling station 23 are positioned substantially aligned along an axis parallel to the translation axes 7 of the respective linear actuators 6, interposed between the translation axes 7 of the respective linear actuators 6. Preferably, the loading station 22, the handling robot 5 and the cooling station 23 are positioned substantially aligned along the symmetry plane 27.

Advantageously, an epitaxial reactor 4 thus configured has a smaller footprint than the prior art.

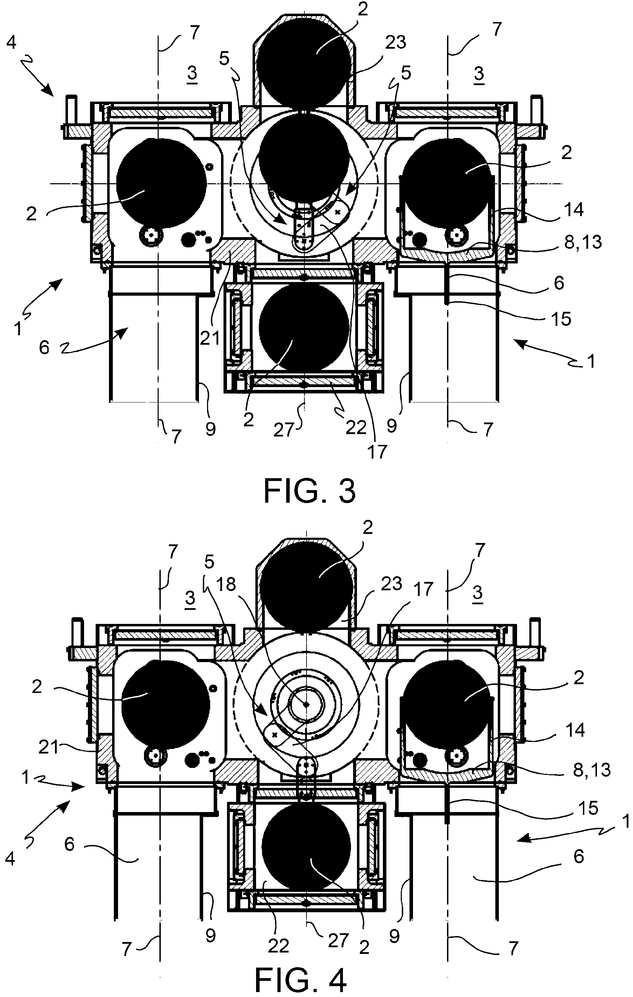

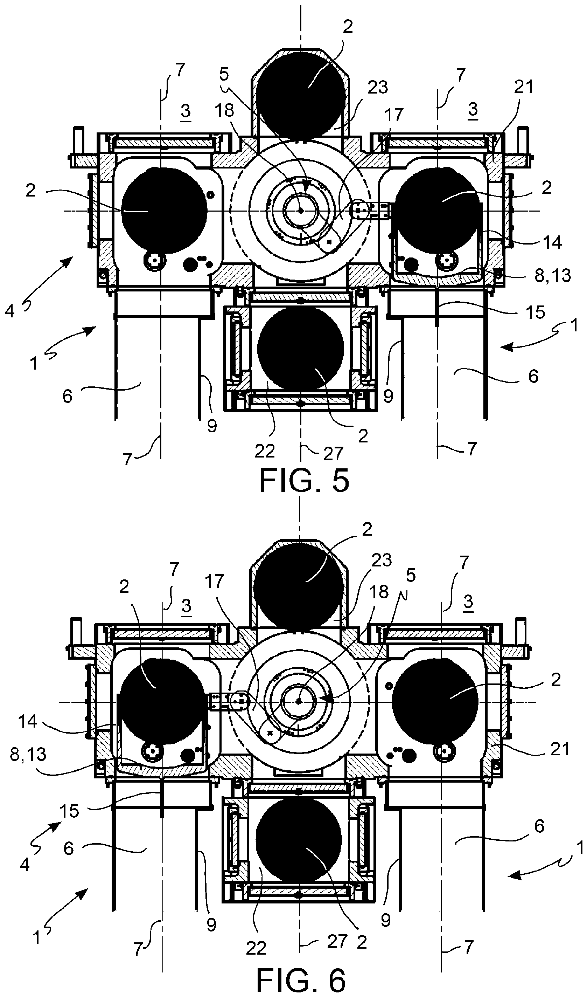

According to one embodiment, the loading station 22, the cooling station 23 and the transfer positions 26 of the respective linear actuators 6 are arranged in a rhomboidal configuration, preferably symmetrical with respect to a symmetry plane 27 parallel to the translation axis 7 defined by the linear actuators 6 and passing by the handling robot 5, and even more preferably centered in the fulcrum end 18 of the handling robot 5 **(****Fig. 3-6****).**

Of course, the person skilled in the art will be able to make modifications or adaptations to the present invention, but not outside the scope of the claims set forth below.

### REFERENCES

- 1.: Loading and unloading system
- 2.: Wafer
- 3.: Reaction chamber
- 4.: Epitaxial reactor
- 5.: Handling robot
- 6.: Linear actuator
- 7.: Direction of movement
- 8.: Transport device
- 9.: Binary
- 10.: Start of travel limit
- 11.: End of travel limit
- 12.: Drive system
- 13.: Fork
- 14.: Prongs
- 15.: Handle
- 16.: Lifting system
- 17.: Articulating arm
- 18.: Fulcrum end
- 19.: Gripping end
- 20.: Handling terminal
- 21.: Frame
- 22.: Loading station
- 23.: Cooling station
- 24.: Start of travel position
- 25.: End of travel position
- 26.: Transfer position
- 27.: Symmetry plane

## Claims

1. A system (1) for loading and unloading wafers (2) in a reaction chamber (3) of an epitaxial reactor (4), the system (1) comprising:
- a handling robot (5);
- a linear actuator (6), extended along a translation axis (7),
wherein the handling robot (5) is configured to transfer a wafer (2) to the linear actuator (6), and wherein the linear actuator (6) is configured to receive the wafer (2) from the handling robot (5) and to move the wafer (2) along the translation axis (7) so as to position the wafer (2) inside the reaction chamber (3).

2. System (1) according to claim 1, wherein the linear actuator (6) comprises a transport device (8) configured to receive and support the wafer (2) transferred from the handling robot (5), wherein the transport device (8) is configured to transport the wafer (2) along the translation axis (7) so as to load the wafer (2) inside the reaction chamber (3),
and wherein the linear actuator (6) comprises a track (9) extended in a direction parallel to the translation axis (7),
wherein the transport device (8) is connected to the track (9),
and wherein the track (9) is configured to guide the movement of the transport device (8) along the translation axis (7).

3. System (1) according to claim 2, wherein the transport device (8) is a fork (13), comprising at least two prongs (14), preferably only two prongs (14), and a handle (15) connected to at least two prongs (14),
wherein the fork (13) is facing the reaction chamber (3),
wherein the prongs (14) and the handle (15) are positioned substantially parallel to the translation axis (7),
and wherein the handle (15) is positioned opposite the reaction chamber (3) relative to the prongs (14).

4. System (1) according to claim 2, wherein the transport device (8) can be moved from a start of travel position (24) to an end of travel position (25), at the reaction chamber (3), and at a transfer position (26) interposed between the start of travel position (24) and the end of travel position (25),
wherein the transport device (8) is configured to receive the wafer (2) from the handling robot (5) when the transport device (8) is positioned in the transfer position (26),
wherein the transport device (8) is configured to transfer the wafer (2), following processing, to the handling robot (5), when the transport device (8) is positioned in the transfer position (26),
and wherein the handling robot (5) is positioned laterally to the linear actuator (6), at the transfer position (26).

5. System (1) according to claims 3 and 4, wherein the start of travel position (24) corresponds to a fork position (13) wherein an end of the handle (15) opposite the prongs (14) is positioned substantially at a start of travel limit (10) of the track (9),
wherein the end of travel position (25) corresponds to a fork position (13) wherein the end of the handle (15) opposite the prongs (14) is positioned substantially at an end of travel limit (11) of the track (9), and wherein, in the end of travel position (25), the prongs (14) extend beyond the track (9) and the handle (15) protrudes from the track (9).

6. System (1) according to any of the previous claims, comprising a lifting system (16) connected to the linear actuator (6),
wherein the lifting system (16) is configured to move the linear actuator (6) along a direction transverse to the translation axis (7),
wherein, preferably, the lifting system (16) is a hydraulic- or pneumatic- or electromechanical-type system.

7. System (1) according to any of the previous claims, comprising two linear actuators (6) positioned opposite to the handling robot (5), wherein the linear actuators (6) are positioned parallel to each other, and wherein each linear actuator (6) can be positioned facing a respective reaction chamber (3),
and wherein, preferably, the two linear actuators (6) are mirror positioned with respect to a symmetry plane (27) vertical and parallel to the translation axis (7) and passing by the handling robot (5).

8. System (1) according to claim 7, comprising four linear actuators (6) defining two pairs of linear actuators (6), wherein the two pairs of linear actuators (6) are respectively positioned opposite to the handling robot (5), wherein the linear actuators (6) of each pair of linear actuators (6) are adjacent and parallel to each other.

9. System (1) according to any of the previous claims, wherein the handling robot (5) is positioned laterally to one or more linear actuators (6), wherein the handling robot (5) is configured to transfer a wafer (2) to the linear actuator (6), or pick up the wafer (2) from the linear actuator (6), moving the wafer (2) along a direction substantially transverse to the translation axis (7).

10. System (1) according to any of the previous claims, wherein the handling robot (5) comprises an articulated arm (17) extended between a fulcrum end (18) and an opposite gripping end (19), and comprises an end effector (20) connected to the articulated arm (17) at the gripping end (19), wherein the end effector (20) is configured to move the wafers (2) and is configured to deposit or pick the wafers (2) from the linear actuator (6), and in particular from a transport device (8),
and wherein the end effector (20) can be moved on a handling plane, parallel to the translation axis (7), fixed to a frame (21) of the epitaxial reactor (4).

11. An epitaxial reactor (4), comprising at least one reaction chamber (3) and a loading and unloading system (1) according to any one of the previous claims,
wherein the reaction chamber (3) is positioned along the translation axis (7) defined by the linear actuator (6), facing the linear actuator (6),
and wherein the linear actuator (6) is configured to move the wafer (2) along the translation axis (7), in the direction of the reaction chamber (3).

12. Epitaxial reactor (4) according to claim 11, comprising two reaction chambers (3),
wherein the system (1) comprises two linear actuators (6) and a handling robot (5) interposed between the two linear actuators (6), wherein the linear actuators (6) are positioned parallel to each other,
and wherein the reaction chambers (3) are facing a respective linear actuator (6), and wherein, optionally, the two reaction chambers (3) and the two linear actuators (6) are mirror positioned with respect to a symmetry plane (27) parallel to the translation axis (7) defined by the linear actuators (6) and passing by the handling robot (5).

13. Epitaxial reactor (4) according to claim 12, comprising a loading station (22) configured to store a plurality of wafers (2) to be used in the reaction chambers (3) for the epitaxial deposition process, wherein the handling robot (5) is configured to pick up from the loading station (22) a wafer (2) to be used in the reaction chamber (3), and to be transferred to a linear actuator (6),
wherein the epitaxial reactor (4) comprises a cooling station (23) configured to store a plurality of wafers (2) coming from the reaction chambers (3), and wherein the cooling station (23) is distinct from the loading station (22),
wherein the loading station (22) and the cooling station (23) are positioned interposed between the linear actuators (6) and the reaction chambers (3) of the epitaxial reactor (4), and, optionally, wherein the handling robot (5) is positioned interposed between the loading station (22) and the cooling station (23),
and, optionally, the handling robot (5), the loading station (22) and the cooling station (23) are positioned substantially aligned along an axis parallel to the translation axes (7) of the respective linear actuators (6), interposed between the translation axes (7) of the respective linear actuators (6).
